# EUROPEAN PATENT SPECIFICATION

(11) **EP 0 727 841 B1**
(45) Date of publication and mention of the grant of the patent: **26.04.2006**
(21) Application number: 96400307.3
(22) Date of filing: 14.02.1996
(51) Int. Cl.: H01R 9/24, B60R 16/02, H01R 12/38

(54) **Branch junction box**
Abzweigdose
Boîtier de dérivation

(30) Priority: 14.02.1995 JP 2528195
(43) Date of publication of application: 21.08.1996
(73) Proprietor: Sumitomo Wiring Systems, Ltd., Yokkaichi City Mie 510 (JP)
(72) Inventor: Murakami, Koji, c/o Sumitomo Wiring Systems, Ltd., Yokkaichi-city, Mie 510 (JP)
(74) Representative: Bertrand, Didier

(56) References cited:
- WO-A-94/29145
- US-A- 4 072 377
- US-A- 5 227 955
- US-A- 5 249 973
- PATENT ABSTRACTS OF JAPAN vol. 013, no. 503 (E-844), 13 November 1989 & JP 01 202109 A (SUMITOMO ELECTRIC IND LTD), 15 August 1989,

## Description

The present invention relates to the field of electrical wiring for vehicles or the like. More particularly, the present invention relates to an interconnection system for branching and connecting wiring harnesses, and a branch junction box implementing such a system.

A branch junction connector can be based on a bus bar wiring system in which wiring harness connecting terminals are interconnected through the bus bar wiring. To this end, the bus bar wiring is formed by cutting linear or thin bent metallic sheets into narrow bands. Other connecting systems are based on printed circuit boards on which wiring is added in the form of copper layers. The branch junction boxes comprising the aforementioned bus bar wiring system can withstand strong electric currents. However, the cutting and forming of the thin metallic sheets is labor intensive and the approach is not amenable to a scaling up of the integration of the branch junction box. On the other hand, in the branch junction box comprising the print-wired circuit, it is relatively easy to form the circuit wiring system and miniaturisation is possible. However, the printed wire circuit cannot withstand high currents.

As a way of solving the above-mentioned problem, a branch junction box has been described in JP-A-1 202 109. When configured for connecting terminals, the branch junction box combines a bus bar wiring system for strong current capacity connections and a sheet wiring system using a flexible printed circuit (FPC) for weak and moderate current connections. In this way, means are provided for accommodating strong currents whilst enabling the dimensions of the box to remain reasonably small.

In branch junction boxes comprising FPC sheet wiring systems, connecting terminals are formed by reinforcing FPC terminals that are integrally formed with the FPC sheet.

Fig. 9 shows an example of such a connecting terminal, wherein a connector housing 10 on the branch junction box 11 is integrally provided with a reinforcing wall 12, the latter then being covered with an FPC terminal 13.

Fig. 10 shows another example of a connecting terminal in which a protruding portion 14 is provided at an internal face of the connector housing 10, whilst an FPC terminal 13 is provided with a hole 13a for hooking the protruding portion. Thus, the FPC terminal 13 is fixed by hooking the protruding portion 14 into the hole 13a.

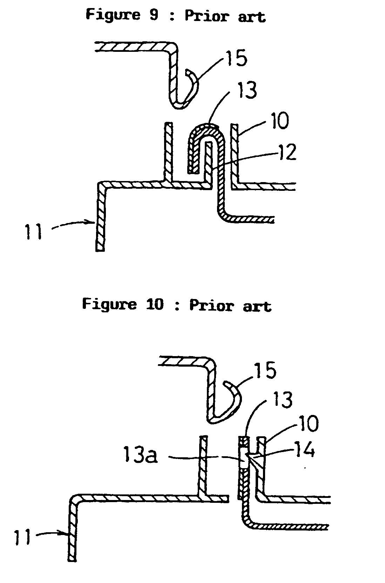

As shown in Figs. 9 and 10, the connecting terminal 15 of a wiring harness is formed by elastically bending a narrow metallic band along a part of its length. This terminal 15 is inserted into a connector housing 10 and connected to a connecting terminal therein.

However, the FPC sheet in such a known branching junction box 11 is thin and easily bent, so that it is difficult to secure it reliably in the branch junction box 11. Moreover, when the box 11 is composed of a lower case and an upper case (not shown in figures), the FPC sheet may be nipped between the two case sections when the latter are assembled, with the risk of cutting off a portion of the sheet wiring.

Moreover, the FPC terminal 13, being integral with a FPC sheet, has to be thin and soft. This makes it difficult to work the terminal through and insert it securely into the connector housing 10. Further, the electrical connection between the FPC terminal 13 on the side of the branch junction box 11 and the connecting terminal 15 on the side of the wiring harness requires a certain amount of resilience in the wiring at the harness side of the connecting terminal 15. In such a structure, when branch junction box 11 is deformed by heat, e.g. generated within a vehicle, especially at the level of the connector housing 10, proper electrical contact may no longer be ensured between the FPC terminal 13 and the connecting terminal 15.

Further, US-A-5227955 discloses an interconnection system for connecting wiring harnesses, comprising a flexible printed circuit comprised of a flexible sheet provided with a printed circuit, a plurality of electrical circuit terminals to be connected with the wiring harnesses, the terminals having first and second end portions, an insulating plate having a first face confronting the flexible sheet and a second face, means for securing the insulating plate to the flexible sheet, the insulating plate and the flexible sheet being provided with a plurality of first path holes passing substantially perpendicularly through the insulating plate and the flexible sheet, the circuit terminals being fitted through the first path holes so that the terminals are mechanically fixed to the insulating plate, and means for electrically connecting the first end portion of the terminal to the printed circuits, whereby a second end of the terminals, opposite the first end, is adapted to be connected to the wiring harnesses.

It is therefore an object of the present invention to solve each of the above-mentioned problems by providing an interconnecting system for wiring harnesses and a branch junction box containing the latter, in which a thin and foldable FPC sheet is easily fixed without being impaired and in which connecting terminals are easily installed, thereby enabling proper electric contact with a wiring harness.

To solve the above-mentioned problem, there is provided an interconnection system for connecting wiring harnesses, comprising: at least one flexible printed circuit comprised of a flexible sheet provided with a printed circuit; a plurality of electrical circuit terminals to be connected with the wiring harnesses, the terminals having first and second end portions; at least one insulating plate having a first face confronting the flexible sheet and a second face; means for securing the insulating plate to the flexible sheet, the insulating plate and the flexible sheet being provided with a plurality of first path holes passing substantially perpendicularly through the insulating plate and the flexible sheet, the circuit terminals being fitted through the first path holes so that said terminals are mechanically fixed to the insulating plate; and means for electrically connecting the first end portion of the terminal to the printed circuits, whereby a second end of the terminals, opposite the first end, is adapted to be connected to the wiring harnesses.

The circuit terminals may comprise a head part of comparatively large diameter and a leg part of comparatively small diameter, the path holes of the insulating plate define a stepped profile across a thickness section of the insulating plate, corresponding to a cross-section of the head part, on the second face of the insulating plate and corresponding to a cross-section of the leg part on the first face thereof, wherein the terminals are received into the first path holes from the leg part end, and wherein the leg part end is fixed on the printed circuit by means of an electrically conducting material.

It is also possible to provide the circuit terminals with a flange on the head part thereof, the flange providing mechanical support means for the head part.

The insulating plate can be provided with bus bar wiring patterns on the second face of the insulating plate, the patterns being provided with a plurality of bus bar terminals projecting substantially perpendicularly from the second face.

The insulating plate and flexible sheet can further be provided with second path holes, whereby a group of bus bar terminals pass through the second holes and project substantially perpendicularly from the first face confronting said flexible sheet.

Preferably, the insulating plate is integrally provided with protruding elements on at least one face thereof, whereupon the flexible sheet and/or the bus bar wiring patterns is/are provided with holes at positions corresponding to the protruding elements. The sheet and/or patterns is/are then fixed to the insulating plate by fitting the protruding elements into the holes.

A second insulating plate may be placed on the bus bar wiring patterns of the first insulating plate. The second plate can carry at least one of a flexible sheet and a bus bar wiring pattern with corresponding circuit terminals or bus bar terminals. It can be further provided with path holes, through which the circuit terminals and bus bar terminals of the first insulating plate pass and project outwardly.

At least one face of the first insulating plate can be provided with fixing means for holding electronic components.

The invention also provides a branch junction box comprising a case including an upper case portion, a lower case portion and an interconnection system according to one of the above-mentioned embodiments, the interconnection system being disposed within the case, the upper case portion being provided with connector housings for receiving the circuit terminals and/or the bus bar terminals and the lower case portion comprising, where appropriate, holes for receiving further bus bar terminals for external connection.

The above and other objects, features and advantages of the invention will be made apparent from the following description of the preferred embodiments, given as a non-limiting example, with reference to the accompanying drawings, in which:

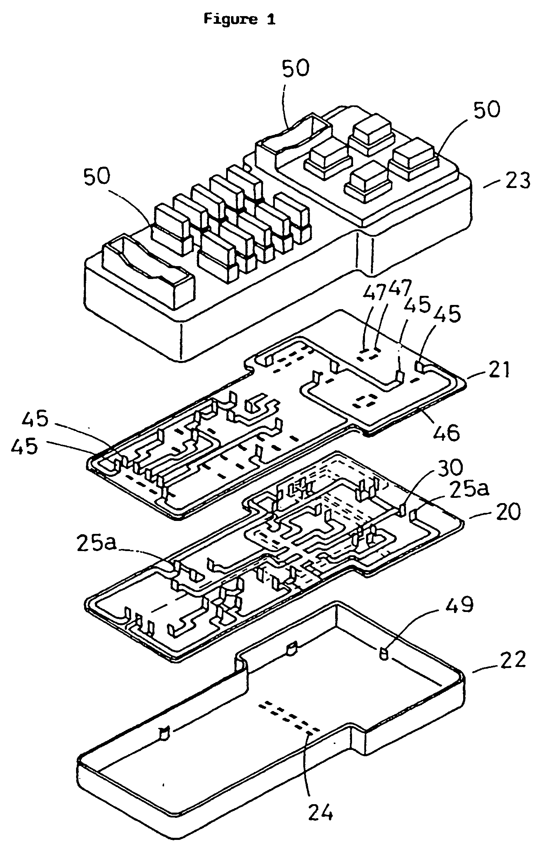

Fig. 1 is an exploded perspective view of a branch junction box according to the present invention;

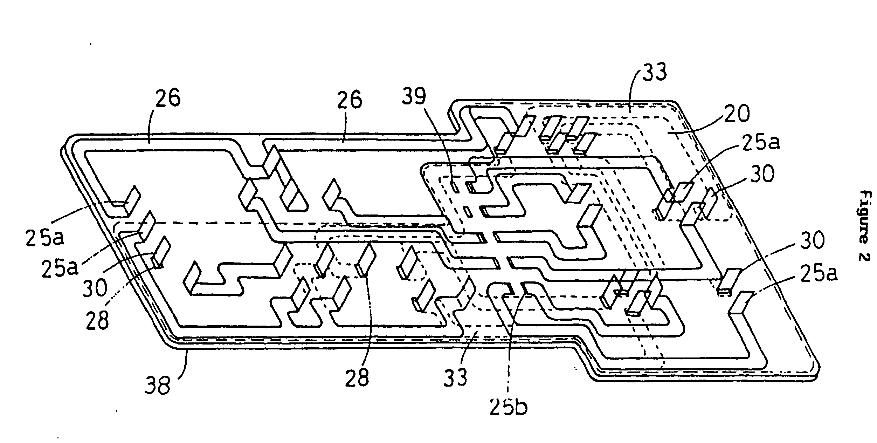

Fig. 2 is a perspective view of a first insulating plate according to the present invention;

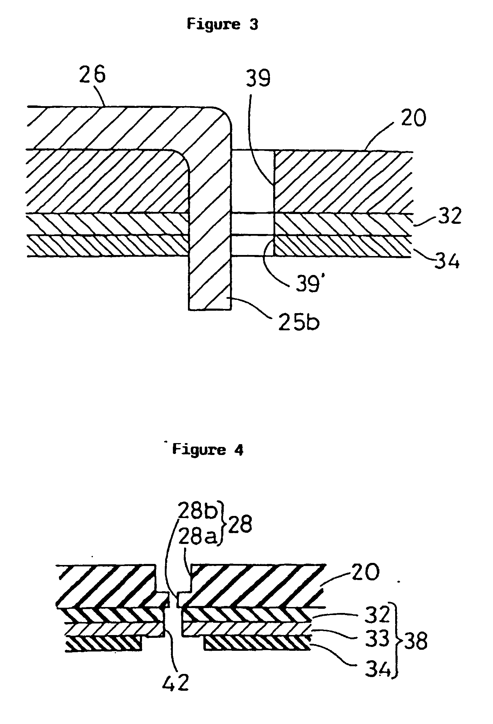

Fig. 3 is a sectional view of a first bus bar wiring pattern according to the present invention;
Fig. 4 is a sectional view of a superposed first insulating plate and flexible printed circuit sheet, showing a through hole for fitting a circuit terminal;

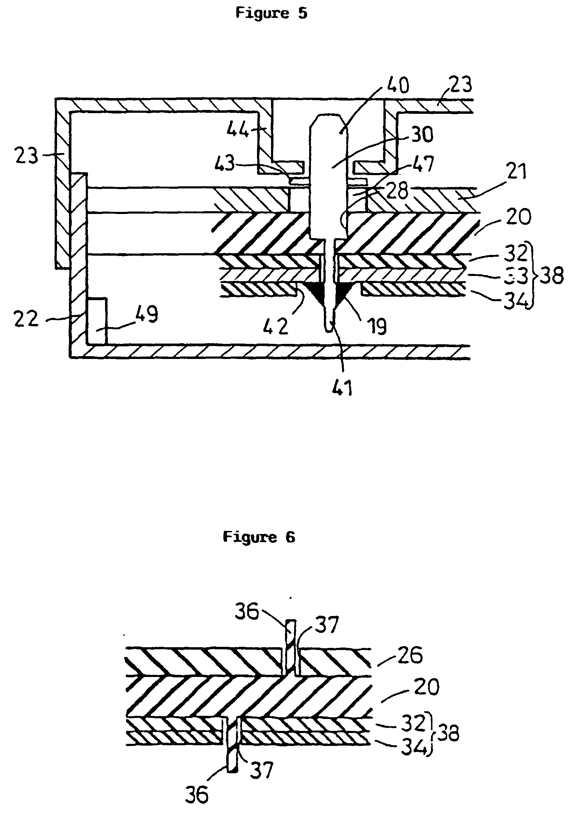

Fig. 5 is a partial cross-sectional view of a branch junction box according to the invention equipped with first and second insulating plates;
Fig. 6 is a sectional view of the first insulating plate with protruding parts, equipped with a flexible printed circuit sheet and a bus bar wiring pattern;

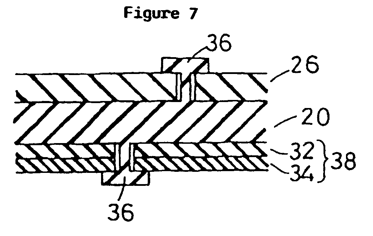

Fig. 7 is a sectional view as in figure 6 above, showing a fixed state by the protruding parts;

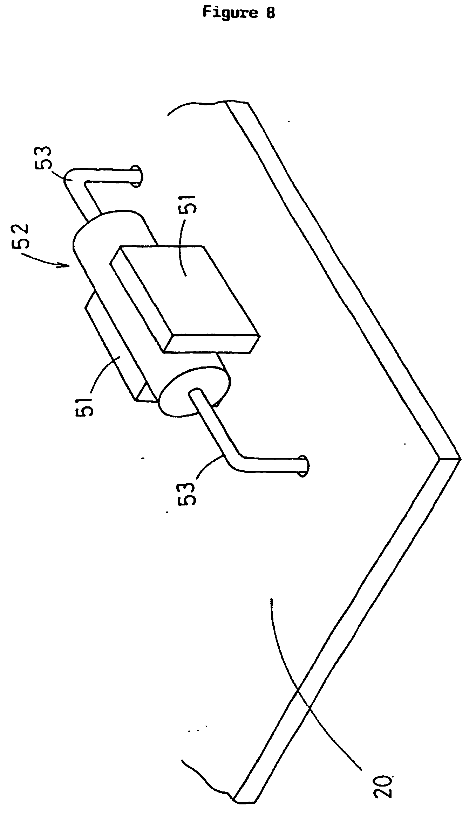

Fig. 8 is a perspective view of the fixing means assembled on one side of the insulating plate;
Fig. 9 is a sectional view of a known connecting terminal;
Fig. 10 is a sectional view of another known connecting terminal.

Referring to Figs. 1 and 2, first and second insulating plates 20 and 21, both made of an insulating resin, have a thickness suitable for pressing and fixing terminals thereinto. They may be 2 to 5 mm thick, comparatively thicker than known insulating plates, the latter being generally 1 to 2 mm thick. These plates are accommodated in a two-part case comprised of lower and upper case portions 22, 23. The second insulating plate 21 is stacked on an upper face of the first insulating plate 20.

The upper face of the first insulating plate 20 is provided with first bus bar terminals 25a projecting upwardly at positions corresponding to connector housings 50 formed at the upper case portion 23.

First bus bar terminals 25b (figure 2) are also provided projecting downwardly from the first insulating plate 20 at positions corresponding to holes 24 formed in the lower case portion 22. These bus bar terminals 25b provide external connections at the lower case portion 22, as shall be explained in more detail below. The first bus bar terminals 25a and 25b are respectively electrically connected by first bus bar wiring patterns 26.

Each first bus bar terminal 25a, 25b and their respective first bus bar wiring patterns 26 are integrally formed from a metallic strip that is shaped to define a path along the plate and bent at both of its ends to form the terminals 25a, 25b.

The upper face of the first insulating plate 20 may also be provided with circuit terminals 30 at the positions corresponding to the connector housings 50 in the upper case portion 23, as shall be explained in more detail below.

As shown in Fig. 2 (dotted lines) and in Figs. 3 to 5, the lower face of the first insulating plate 20 is provided with a flexible printed circuit sheet 38. The latter comprises an insulating film 32 of about 12 to 250 µm thickness, and preferably around 125 µm, made of polyester, polyimide, etc.; an underlying circuit wiring 33 of about 18 to 200 µm thickness, preferably around 70 µm, made of copper plate; and a cover film 34 of around 12 to 125 pm thickness.

The first insulating plate 20 is therefore thicker than the sheet 38 of the flexible printed circuit and relatively rigid so as to form a mechanical support for the flexible printed circuit 38.

As shown in Fig. 3, the downwardly projecting first bus bar terminals 25b are passed through holes 39 formed in the first insulating plate 20 and through the holes 39' formed in the flexible sheet.

Figs. 4 and 5 show a method for fixing a printed circuit terminal 30 of figure 2 to the first insulating plate 20.

For this purpose, through-holes 28 are formed in the first insulating plate 20 at positions from which the circuit terminals 30 project. Each through-hole 28 presents a different size opening on each face of the first insulating plate 20, the opening 28a at the upper face being relatively large and opening at the lower face 28b being relatively small. The openings 28 thus define a stepped profile through the thickness of the first insulating plate 20.

The flexible printed circuit board 38 is provided with through-holes 42 at the positions corresponding to the step-wise hole portion 28, so that the cover film 34 exposes the circuit wiring 33.

Then, as shown in Fig. 5, a circuit terminal 30 composed of a head part 40 and a thinner leg part 41 is press fitted into the step-wise hole portion 28 and vertically aligned, so that the head part 40 projects upwardly from the first insulating plate 20 and the leg 41 projects downwardly from the first insulating plate 20.

The hole portion 28 is designed so that the circuit terminal 30 is fixed securely to the insulating plate 20.

The leg 41 projecting through the hole 42 is connected to printed circuits 33 by soldered joints 19, so that the circuit terminals 30 are electrically connected to one another through the printed circuits 33. The head 40 is provided with a flange 43 which cooperates with a bottom surface of the upper case portion 23, so that, after being covered with the upper case portion 23, the circuit terminal 30 is reinforced against tractive forces exerted by the harness.

To this end, the bottom surface of the upper case portion 23 may be provided with downwardly extending sections 44 which abut against the flange 43.

Where a second insulating plate 21 is to be placed over the first insulating plate 20, the holes 47 of the second insulating plate 21 have a size larger than that of the flange 43, so that the flange 43 can pass through its corresponding hole 47 and appear over both of the plates 20 and 21.

However, cooperation between sections 44 of the upper casing portion 23 and flanges 43 of the corresponding circuit terminal 30 is not specific to the embodiment based on first and second insulating plate 20, 21, but can be applied to embodiments based on just a first insulating plate 20 or any other embodiment of the invention.

The first flexible sheet 38 and the first bus bar wiring patterns 26 are fixed to the first insulating plate 20 as shown in Figs. 6 and 7.

The first insulating plate 20 is integrally provided, at both its faces, with protruding elements 36. The sections of flexible sheet 38 not equipped with the printed circuits 33 and the first bus bar wiring patterns 26 are provided with path holes 37 at the positions corresponding to the protruding elements 36, so that the latter can be fitted into the path holes 37. The heads of the protruding elements 36 are soldered or brazed onto the first bus bar wiring patterns 26 and the flexible sheet 38 (Fig. 7). In this way, the flexible sheet 38 and the bus bar wiring patterns 26 are easily fixed to the first insulating plate 20.

The second insulating plate 21, stacked onto the first insulating plate 20, is provided with path holes 47 that receive the first bus bar terminals 25a and circuit terminals 30 of the first insulating plate 20. When the first and the second insulating plates 20, 21 are stacked, the circuit terminals 30 and the bus bar terminals 25a protrude upwardly from the second insulating plate 21.

As shown in Fig. 1, the second insulating plate 21 may be provided, at its upper face, with second bus bar terminals 45 and second bus bar wiring patterns 46 formed in the same way as the first bus bar terminals 25a and the bus bar wiring patterns 26 on the upper face of the first insulating plate 20.

The first and the second insulating plates 20, 21 are stacked in the lower case portion 22 and held in place by a supporting spigot 49 provided therein. They are then covered with the top case portion 23 to form a branch junction box.

The circuit terminals 30, first bus bar terminals 25a and second bus bar terminals 45 are accessible through the connector housings 50 at the upper case portion 23, and thereby serve as connectors for the contact with a wire harness.

The first bus bar terminals 25b are passed through the holes 24 in the lower case portion 22 and project downwardly therefrom, thereby providing a connection for the first bus bar wiring patterns to additional external connectors.

In accordance with the present branch junction box, the circuit terminals 30 are pressed into the first insulating plate 20 and vertically fixed. Therefore, it is not necessary, as it was in the past, to form a flexible printed circuit terminal by transforming a thin and difficult-to-work flexible sheet 38. Accordingly, assembly is simplified and the structure possesses greater solidity. Also, the quality of the electrical contact does not depend on the resilience of a connecting terminal of the wiring harness. Thus, even when the upper and lower case portions 22, 23 are deformed by heat, the electrical contact with the wiring harness will not be impaired, and proper contact is still ensured.

Also, because the flexible sheet 38 is fixed along the lower face (Fig. 1) of the first insulating plate 20, the thin and foldable flexible sheet 38 is easily fitted into the branch junction box without being damaged when assembling the bottom-and-top-side cases 22, 23.

Further, the printed circuits 33 in the flexible sheet 38, the first bus bar wiring patterns 26 and the second bus bar wiring patterns 46 may be amalgamated such that a wire harness for large electric current is branch-connected with the first and second bus bar wiring patterns 26, 46, whilst a wire harness for small electric current is branch connected with the printed circuits 33. In this way, the wire harnesses for both large and small currents are efficiently branch-wired in a small branch junction box.

As shown in Fig. 8, the first insulating plate 20 may be provided, on its upper face (Fig. 1), with a pair of fixing members 51 for mounting an electronic component 52. In this case, the electronic component 52 is first fixed into place, and then an end 53 of the component 52 is fixed to the first bus bar wiring patterns 26 or printed circuits 33 by soldering in a known way. Thus, the electronic component 52 is conveniently and easily mounted.

When the electronic component 52 is fixed on the first insulating plate 20, its handling process may be easily mechanically automated, thereby improving productivity.

The second insulating plate 21 may be stacked with a plurality of further layers, so that more wire harnesses are branch-wired. Conversely, the first insulating plate 20 alone, without using the second insulating plate 21, may suffice in some applications case.

Further, the circuit terminal 30 may be of any shape that can pressingly be fixed into the insulating plate 20, such as a thin rod-type pin or similar.

## Claims

1. Interconnection system for connecting wiring harnesses, comprising:
- at least one flexible printed circuit comprised of a flexible sheet (38) provided with a printed circuit (33);
- a plurality of electrical circuit terminals (30) to be connected with said wiring harnesses, said terminals (30) having first and second end portions;
- at least one insulating plate (20) having a first face confronting said at least one flexible sheet (38) and a second face;
- means (36, 37) for securing said at least one insulating plate (20) to said at least one flexible sheet (38), said insulating plate (20) and said flexible sheet (38) being provided with a plurality of first path holes (28) passing substantially perpendicularly through said insulating plate (20) and said flexible sheet (38), said circuit terminals (30) being fitted through said first path holes (28) so that said terminals (30) are mechanically fixed to said insulating plate (20); and
- means (19) for electrically connecting said first end portion of the terminal (30) to said printed circuits (33), whereby a second end of said terminals (30), opposite said first end, is adapted to be connected to the wiring harnesses;
**characterized in that** said circuit terminals (30) comprise a head part (40) of comparatively large diameter and a leg part (41) of comparatively small diameter, said path holes (28) of said insulating plate (20) define a stepped profile across a thickness section of said insulating plate (20), corresponding to a cross-section of said head part (40), on said second face of said insulating plate (20) and corresponding to a cross-section of said leg part (41) on said first face thereof wherein said terminals (30) are received into said first path holes (28) from the leg part end, and wherein said leg part end is fixed on said at least one printed circuit (33) by means of an electronically conducting material (19).

2. Interconnection system according to claim 1 wherein said first circuit terminals (30) are further provided with a flange (43) on said head part (40) thereof, said flange (43) providing mechanical support means for said head part (40).

3. Interconnection system according to claims 1 or 2 further comprising bus bar wiring patterns (26) provided on the second face of the insulating plate (20), said patterns (26) being provided with a plurality of bus bar terminals (25a) projecting substantially perpendicularly from said second face.

4. Interconnection system according to claim 3 wherein said at least one insulating plate (20) and said at least one flexible sheet (38) are provided with second path holes (39, 39') and wherein a group of said bus bar terminals (25b) pass through said second holes (39, 39') and project substantially perpendicularly from said first face confronting said flexible sheet (38).

5. Interconnection system according to claim 3 or 4 wherein the said at least one insulating plate (20) is integrally provided with protruding elements (36) on at least one face thereof, at least one of said at least one flexible sheet (38) and said bus bar wiring patterns (26) is provided with holes (37) at positions corresponding to said protruding elements (36) and wherein said sheet (38) and/or patterns (26) is/are fixed to said insulating plate (20) by fitting said protruding elements (36) into said holes (37).

6. Interconnection system according to any one of claims 1 to 5 further comprising at least one second insulating plate (21) placed on said bus bar wiring patterns (26) of said at least one first insulating plate (20), and wherein said at least one second plate (21) carries at least one of a flexible sheet and bus bar wiring patterns (46) with corresponding circuit or bus bar terminals (45) thereof and wherein said second insulating plate (21) is provided with path holes (47), through which said circuit terminals (30) and bus bar terminals (25a) of said at least one first insulating plate (20) pass and project outwardly.

7. Interconnection system according to any one of claims 1 to 6 wherein at least one face of said insulating plates (20, 21) is provided with fixing means (51) for holding electronic components (52).

8. A branch junction box comprising a case including an upper case portion (23), a lower case portion (22) and an interconnection system according to any one of claims 1 to 7 said interconnection system being disposed within said case, said upper case portion (23) being provided with connector housings (50) for receiving said circuit terminals (30) and/or said bus bar terminals (25a) and said lower case portion (22) comprising, where appropriate, holes (24) for receiving further bus bar terminals (25b) for external connection.

## Revendications

1. Système d''interconnexion pour connecter des faisceaux de câblage, comprenant :
au moins un circuit imprimé flexible constitué d'une feuille flexible (38) pourvue d'un circuit imprimé (33) ;
une pluralité de bornes de circuit électrique (30) à connecter avec les dits faisceaux de câblage, les dites bornes (30) ayant une première et une deuxième parties d'extrémité :
au moins une plaque isolante (20) ayant une première face en regard de la dite au moins une feuille flexible (38) et une deuxième face ;
des moyens (36, 37) de fixation de la dite au moins une plaque isolante (20) à la dite au moins une feuille flexible (38), la dite plaque isolante (20) et la dite feuille flexible (38) comportant une pluralité de premiers trous de passage (28) qui traversent sensiblement perpendiculairement la dite plaque isolante (20) et la dite feuille flexible (38), les dites bornes de circuit (30) étant montées à travers les dits premiers trous de passage (28) de sorte que les dites bornes (30) sont mécaniquement fixées à la dite plaque isolante (20) ; et
des moyens (19) pour connecter électriquement la dite première partie d'extrémité de la borne (30) aux dits circuits imprimés (33), de sorte qu'une deuxième extrémité des dites bornes (30), à l'opposé de la dite première extrémité, est prévue pour être connectée aux faisceaux de câblage ; **caractérisée en ce que** les dites bornes de circuit (30) comprennent une tête (40) de diamètre relativement grand et une jambe (41) de diamètre relativement petit, les dits trous de passage (28) de la dite plaque isolante (20) définissent un profil épaulé à travers une épaisseur de la dite plaque isolante (20), correspondant à une section transversale de la dite tête (40) sur la dite deuxième face de la dite plaque isolante (20) et correspondant à une section transversale de la dite jambe (41) sur sa dite première face, dans lequel les dites bornes (30) sont reçues dans les dits premiers trous de passage (28) par l'extrémité côté jambe, et dans lequel la dite extrémité côté jambe est fixée sur le dit au moins un circuit imprimé (33) au moyen d'une matière électriquement conductrice (19).

2. Système d'interconnexion selon la revendication 1, dans lequel les dites premières bornes de circuit (30) comportent en outre une collerette (43) sur leur dite tête (40), la dite collerette (43) procurant un moyen de support mécanique pour la dite tête (40).

3. Système d'interconnexion selon les revendications 1 ou 2, comprenant en outre des configurations de câblage de barre de distribution (26) prévues sur la deuxième face de la plaque isolante (20), les dites configurations (26) comportant une pluralité de bornes de barre de distribution (25a) qui font saillie sensiblement perpendiculairement par rapport à la dite deuxième face,

4. Système d'interconnexion selon la revendication 3, dans lequel la dite au moins une plaque isolante (20) et la dite au moins une feuille flexible (38) comportent des deuxièmes trous de passage (39, 39'), et dans lequel un groupe de dites bornes de barre de distribution (25b) traversent les dits deuxièmes trous (39, 39') et font saillie sensiblement perpendiculairement par rapport à la dite première face en regard de la dite feuille flexible (38).

5. Système d'interconnexion selon la revendication 3 ou 4, dans lequel la dite au moins une plaque isolante (20) est solidairement pourvue d'éléments en saillie (36) sur au moins une de ses faces, au moins une de la dite au moins une feuille flexible (38) et des dites configurations de câblage de barre de distribution (26) comporte des trous (37) à des positions correspondant aux dits éléments en saillie (36), et dans lequel la dite feuille (38) et/ou les dites configurations (26) est/sont fixée(s) à la dite plaque isolante (20) par montage des dits éléments en saillie (36) dans les dits trous (37).

6. Système d'interconnexion selon une quelconque des revendications 1 à 5, comprenant en outre au moins une deuxième plaque isolante (21) placée sur les dites configurations de câblage de barre de distribution (26) de la dite au moins une première plaque isolante (2-0), et dans lequel la dite au moins une deuxième plaque (21) porte au moins une d'une feuille flexible et de configurations de câblage de barre de distribution (46), avec son circuit correspondant ou ses bornes de barre de distribution (45), et dans lequel la dite deuxième plaque isolante (21) comporte des trous de passage (47) à travers lesquels les dites bornes de circuit (30) et les dites bornes de barre de distribution (25a) de la dite au moins une première plaque isolante (20) passent et font saillie vers l'extérieur.

7. Système d'interconnexion selon une quelconque des revendications 1 à 6, dans lequel au moins une face des dites plaques isolantes (20, 21) comporte des moyens de fixation (51) pour tenir des composants électriques (52).

8. Boîte de dérivation comprenant un boîtier incluant une partie supérieure de boîtier (23), une partie inférieure de boîtier (22) et un système d'interconnexion selon une quelconque des revendications 1 à 7, le dit système d'interconnexion étant disposé à l'intérieur du dit boîtier, la dite partie supérieure de boîtier (23) comportant des logements de connecteur (50) pour recevoir les dites bornes de circuit (30) et/ou les dites bornes de barre de distribution (25a), et la dite partie inférieure de boîtier (22) comprenant, s'il y a lieu, des trous (24) pour recevoir d'autres bornes de barre de distribution (25b) pour connexion extérieure.

## Patentansprüche

1. Verbindungssystem für das verbinden bzw. verknüpfen bzw. zusammenschalten von Kabelsträngen bzw. Kalbelnetzen bzw. Kabelbäumen, umfassend:
• zumindest eine flexible bzw. biegsame, gedruckte Schaltung, umfassend ein flexibles bzw. biegsames Blatt bzw. eine flexible bzw. biegsame Platte (38) versehen mit einer gedruckten Schaltung (33);
• eine Mehrzahl von elektrischen Schaltungsanschlüssen (30), die anzuschließen bzw. in Kontakt zu bringen sind mit den Kabelsträngen, wobei die Anschlüsse (30) erste und zweite Endabschnitte aufweisen;
• zumindest eine isolierende Platte (20), welche eine erste Fläche bzw. Seite aufweist, die dem zumindest einem biegsamen Blatt (38) gegenüber steht, und eine zweite Fläche bzw. Seite;
• Mittel bzw. Vorrichtungen (36,37) für das Sichern bzw. Befestigen der zumindest einen isolierenden Platte (20) an dem zumindest einen biegsamen Blatt (38), wobei die isolierende Platte (20) und das biegsame Blatt (38) vorgesehen sind mit einer Mehrzahl von ersten Durchtrittsöffnungen (28), welche im Wesentlichen senkrecht durch die isolierende Platte (20) und das biegsame Blatt (38) gehen, wobei die Schaltungsanschlüsse (30) durch die ersten Durchtrittsöffnungen (28) eingepaßt bzw. eingebaut werden, so dass die Anschlußteile (30) mechanisch befestigt an der isolierenden Platte (20) sind; und
• Mittel bzw. Vorrichtungen (19) für das elektrische anschließen bzw. koppeln bzw. verbinden des ersten Endabschnitts des Anschlusses (30) an die gedruckte Schaltung (33), wobei ein zweites Ende des Anschlusses (30), entgegengesetzt bzw. entgegen gelegen des ersten Endabschnitts, angepaßt ist, mit den Kabelsträngen verbunden zu werden;
**dadurch gekennzeichnet, daß** die Schaltungs-Anschlüsse (30) ein Kopfstück (40) von vergleichbar großem Durchmesser und ein Fußstück (41) von vergleichbar kleinem Durchmesser umfassen, wobei die Durchtrittsöffnungen der isolierenden Platte (20) einen abgestuften bzw. stufigen Querschnitt bzw. ein abgestuftes bzw. stufiges Profil definieren über einen Abschnitt der Dicke der isolierenden Platte (20), entsprechend bzw. passend zu einem Querschnitt des Kopfstücks (40) auf der zweiten Fläche bzw. Seite der isolierenden Platte (20) und entsprechend bzw. passend zu einem Querschnitt des Fußteils (41) auf der ersten Fläche bzw. Seite derselben, wobei die Anschlüsse (30) aufgenommen werden in die ersten Durchtrittsöffnungen (28) vom Ende des Fußteils aus, und wobei das Ende des Fußteils fixiert bzw. befestigt ist auf der zumindest einen gedruckten Schaltung (33) durch ein elektronisch leitendes Material (19).

2. Verbindungssystem entsprechend Anspruch 1, wobei die ersten Schaltungsanschlüsse (30) weiters ausgestattet sind mit einem Kragen bzw. Ring bzw. Flansch (43) an ihrem Kopfteil (40), und der Flansch (43) mechanische Stützmittel für das Kopfteil (40) bereitstellt bzw. bietet.

3. Verbindungssystem nach Ansprüchen 1 oder 2, weiters umfassend Schienen-Verdrahtungs- bzw. Verschaltungsanordnungen bzw. -strukturen (26), bereitgestellt auf der zweiten Fläche bzw. Seite der isolierenden Platte (20), wobei die Anordnungen (26) ausgestattet sind mit einer Mehrzahl an Schienen-Anschlußteilen bzw. -enden (25a), welche im wesentlichen senkrecht bzw. rechtwinklig von der zweiten Fläche bzw. Seite abstehen.

4. Verbindungssystem nach Anspruch 3, wobei die isolierende Platte und das zumindest eine biegsame Blatt (38) mit zweiten Durchtrittsöffnungen (39,39') vorgesehen ist, und wobei eine Gruppe der Schienen-Anschlußteile (25b) durch die zweiten Löcher (39,39') treten und im Wesentlichen senkrecht bzw. rechtwinklig von der ersten Fläche bzw. Seite, welche dem biegsamen Blatt (38) entgegensteht, abstehen.

5. Verbindungssystem nach Ansprüchen 3 oder 4, wobei die zumindest eine isolierende Platte (20) integral bzw. ganzheitlich bzw. einstückig auf zumindest einer ihrer Flächen bzw. Seiten mit hervorstehenden bzw. hervorragenden Elementen (36) versehen ist, zumindest eines oder eine des zumindest einen biegsamen Blattes (38) und der Schienen-Verdrahtungsanordnung (26) versehen ist mit Löchern an Positionen entsprechend den hervorstehenden Elementen (36), und wobei das Blatt (38) und/oder die Anordnungen (26) an der isolierenden Platte (20) fixiert bzw. gehalten werden durch das Einpassen der hervorstehenden Elemente (36) in die Löcher (37).

6. Verbindungssystem entsprechend einem beliebigen der Ansprüche 1-5, weiters umfassend zumindest eine zweite isolierende Platte (21), angeordnet auf der Schienen-Verdrahtungsanordnung (26) der zumindest einen ersten isolierenden Platte (20), und wobei die zumindest eine zweite Platte (21) zumindest eines trägt von einem biegsamen Blatt und Schienen-Verdrahtungsanordnungen (46) mit entsprechenden Schaltungs- oder Schienen-Anschlüssen (45) derselben, und wobei die zweite isolierende Platte (21) mit Durchtrittsöffnungen versehen ist, durch welche die Schaltungs-Anschlüsse (30) und Schienen-Anschlüsse (25a) von der zumindest einen ersten isolierenden Platte (20) hindurchtreten und nach außen abstehen.

7. Verbindungssystem entsprechend einem beliebigen der Ansprüche 1-6, wobei zumindest eine Fläche bzw. Seite der isolierenden Platten (20,21) mit Befestigungs- bzw. Halte-Mitteln (51) versehen ist, zum Halten bzw. Aufnehmen elektronischer Komponenten bzw. Bauelemente (52).

8. Abzweig- bzw. Verzweig- bzw. Verbindungsdose bzw. -behälter, umfassend ein Gehäuse bestehend aus einem oberem Gehäuseabschnitt bzw. -teil (23), einem unterem Gehäuseabschnitt bzw. -teil (22), und einem Verbindungssystem entsprechend einem der Ansprüche 1-7, wobei das Verbindungssystem in dem Gehäuse angeordnet bzw. verteilt ist, das obere Gehäuseteil (23) ausgestattet ist mit Steckergehäusen (50) zum Aufnehmen der Schaltungs-Anschlüsse (30) und/oder der Schienen-Anschlüsse (25a), und das untere Gehäuseteil, wo geeignet, Löcher (24) umfasst, um weitere Schienen-Anschlüsse (25a) aufzunehmen für externe Verbindung bzw. externen Anschluß.
